(19) Europäisches Patentamt
European Patent Office
Office européen des brevets

(11) **EP 3 887 870 B1**

(12) **EUROPÄISCHE PATENTSCHRIFT**

(45) Veröffentlichungstag und Bekanntmachung des Hinweises auf die Patenterteilung:
**16.04.2025 Patentblatt 2025/16**

(21) Anmeldenummer: **19801499.5**

(22) Anmeldetag: **30.10.2019**

(51) Internationale Patentklassifikation (IPC):
**G01V 3/10** (2006.01)     **G01V 13/00** (2006.01)

(52) Gemeinsame Patentklassifikation (CPC):
**G01V 3/10; G01N 27/023; G01V 13/00; H03K 5/01**

(86) Internationale Anmeldenummer:
**PCT/EP2019/079606**

(87) Internationale Veröffentlichungsnummer:
**WO 2020/108906 (04.06.2020 Gazette 2020/23)**

(54) **INDUKTIVE MESSVORRICHTUNG MIT KALIBRIEREINRICHTUNG UND VERFAHREN**

INDUCTIVE MEASURING APPARATUS AND CALIBRATION DEVICE AND METHOD

DISPOSITIF DE MESURE INDUCTIF ET APPAREIL ET PROCÉDÉ D'ÉTALONNAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2018 DE 102018220532**

(43) Veröffentlichungstag der Anmeldung:
**06.10.2021 Patentblatt 2021/40**

(73) Patentinhaber: **Forschungszentrum Jülich GmbH 52425 Jülich (DE)**

(72) Erfinder:
• **TAN, Xihe**
  **52428 Jülich (DE)**
• **ZIMMERMANN, Egon**
  **52459 Inden/Altdorf (DE)**
• **MESTER, Achim**
  **50859 Köln (DE)**
• **VAN DER KRUK, Jan**
  **6291LR Vaals (NL)**
• **GLAAS, Walter**
  **50189 Elsdorf (DE)**
• **DICK, Markus**
  **52499 Baesweiler (DE)**
• **RAMM, Michael**
  **52382 Huchem-Stammeln (DE)**

(74) Vertreter: **Gille Hrabal Partnerschaftsgesellschaft mbB
Patentanwälte
Brucknerstraße 20
40593 Düsseldorf (DE)**

(56) Entgegenhaltungen:
WO-A1-2014/056069     DE-A1- 102009 026 403
DE-A1- 102012 203 111     US-A1- 2003 184 301

EP 3 887 870 B1

**Beschreibung**

Die Erfindung bezieht sich auf eine Messvorrichtung mit einem Sender für ein Senden eines Messsignals, einem Empfänger für ein Empfangen einer Antwort auf das gesendete Messsignal und einer Signalverarbeitungseinrichtung für die Ermittlung eines Messergebnisses aus der Antwort. Der Sender und/oder der Empfänger weisen wenigstens eine Spule auf. Die Messvorrichtung umfasst eine Kalibriereinrichtung für eine Reduzierung eines Störeinflusses auf das Messergebnis. Die Erfindung betrifft ferner ein Verfahren für den Betrieb der Messvorrichtung.

Aus der Druckschrift DE 197 31 560 A1 ist eine Messvorrichtung mit einem Sender für ein Senden eines Messsignals und einem Empfänger für ein Empfangen einer Antwort auf das gesendete Messsignal zum Orten und zur Identifizierung von metallischen Munitionskörpern unterhalb der Erdoberfläche bekannt. Es wird mithilfe einer Sendespule des Senders ein sich zeitlich veränderndes Magnetfeld als Messsignal erzeugt. Durch dieses kann in einem ferromagnetischen Munitionskörper ein Wirbelstrom und damit einhergehend ein Sekundärfeld als Antwort erzeugt werden. Hierdurch wird in Empfangsspulen des Empfängers ein Ortungssignal induziert, welches ausgewertet wird.

Gemäß der EP 1 289 147 A1 wird bei einer Messvorrichtung der eingangs genannten Art durch einen Schwingkreis ein Erregungssignal als Messsignal erzeugt. Durch Annäherung oder Anwesenheit eines Objekts kann das Erregungssignal beeinflusst werden. Dieser Einfluss wird durch einen Empfänger der Messvorrichtung ermittelt. Die ermittelte Antwort wird durch die Messvorrichtung bewertet.

Die Druckschrift DE 10 2009 026 403 A1 offenbart ebenfalls eine Messvorrichtung mit einem Sender für ein Senden eines Messsignals und einem Empfänger für ein Empfangen einer Antwort auf das gesendete Messsignal. Der Sender umfasst einen Primärkreis, welche eine Sendespule enthält. Der Empfänger umfasst einen Sekundärkreis mit Empfängerspule. Es gibt einen Kurzschlusspfad, durch den die Sendespule induktiv mit der Empfängerspule für Diagnosezwecke gekoppelt werden kann.

Die Druckschrift WO 2018/014891 A1 beschreibt ein Kalibrierungsverfahren für elektromagnetische Induktionsmesssysteme sowie eine dafür geeignete Vorrichtung. Es wird ein Kalibrierungsverfahren zur Verfügung gestellt, welches bei Bodenmessungen der scheinbaren elektrischen Leitfähigkeit Einflüsse berücksichtigt, die auf das Messgerät selbst zurückzuführen sind oder aus der Umgebung kommen und die die Messung beeinflussen. Mit dem Verfahren ist die individuelle Kalibrierung eines elektrischen Induktionssystems möglich, welches Umgebungseinflüsse berücksichtigt. Zur Kalibrierung wird ein Induktionsmessgerät mit mindestens einem Sender und mindestens einem Empfänger in mindestens zwei Höhen über dem zu vermessenden Boden aufgebaut und die scheinbaren elektrischen Leitfähigkeiten in einem Vorwärtsmodell berechnet und anschließend in einem Inversionsverfahren optimiert.

Die EP 2 657 726 A2 offenbart ein Verfahren zur elektromagnetischen Messung der elektrischen Leitfähigkeit eines Mediums. Dabei wird das Medium durch eine Sendespule mit einem magnetischen Wechselfeld (Primärfeld) beaufschlagt, so dass im Medium Ströme induziert werden und ein weiteres magnetisches Wechselfeld (Sekundärfeld) ausbilden, wobei das Sekundärfeld mit einer Empfangsspule gemessen und hieraus die Leitfähigkeit des Mediums ausgewertet wird. Erfindungsgemäß wird das Primärfeld am Ort der Sendespule direkt oder indirekt gemessen und hieraus der Beitrag des Primärfeldes zum Feld am Ort der Empfangsspule ausgewertet. Auf Grund des Superpositionsprinzips überlagern sich die Beiträge des Primärfeldes und des Sekundärfeldes zum gesamten Feld am Ort der Sekundärspule störungsfrei. Die in der Sekundärspule induzierte Spannung, die als Messsignal dient, hängt linear von diesem gesamten Feld ab. Daher können der Beitrag des Primärfeldes und damit auch seine temperaturabhängige Drift herauskorrigiert werden, wenn das Primärfeld am Ort der Sendespule und die räumliche Anordnung von Sende- und Empfangsspule zueinander bekannt sind.

Aus der Druckschrift DE 10 2012 203 111 A1 ist ein Verfahren und eine Vorrichtung zur MRT - Bildgebung bekannt. Aus der Druckschrift US 2010/0241389 A1 ist ein System und ein Verfahren im Zusammenhang MRI Anregung bekannt. Ein drahtloser Sensor geht aus der Druckschrift US 2011/0115497 A1 hervor. Die aus der Druckschrift US 2005/0190100 A1 bekannte Erfindung bezieht sich auf Wetter-Radar Kalibrierung. Ein Verfahren zur Ansteuerung eines Magnetresonanzsystems ist aus der Druckschrift DE 10 2011 083 959 A1 bekannt. Die Druckschrift US 2012/0139776A1 offenbart ein Verfahren für den Erhalt von Kalibrierungsparametern für Antennen.

Durch die vorliegende Erfindung soll mit geringem technischen Aufwand mittels einer Messvorrichtung der vorgenannten Art besonders genau gemessen werden können.

Die Aufgabe wird durch eine Messvorrichtung mit den Merkmalen des ersten Anspruchs gelöst. Ein Verfahren umfasst zur Lösung der Aufgabe die Merkmale des Nebenanspruchs. Vorteilhafte Ausgestaltungen ergeben sich aus den Unteransprüchen.

Eine Messvorrichtung umfasst einen Sender für ein Senden eines Messsignals, einen Empfänger für ein Empfangen einer Antwort auf das gesendete Messsignal und eine Signalverarbeitungseinrichtung. Die Signalverarbeitungseinrichtung ist so eingerichtet, dass mit dieser ein gesuchtes Messergebnis aus der Antwort ermittelt werden kann. Der Sender und/oder der Empfänger weisen eine Spule auf. Es ist eine Kalibriereinrichtung vorhanden, um einen Störeinfluss auf das Messergebnis reduzieren zu können. Die Kalibriereinrichtung ist so eingerichtet, dass von einer Stromquelle ein Stromimpuls in die Spule des Empfängers eingeleitet wird. Alternativ oder ergänzend ist die Kalibriereinrichtung so eingerichtet, dass von einer Stromquelle ein Stromimpuls in die Spule des Senders eingeleitet werden kann Durch das Einleiten eines Stromimpulses wird ein Kalibriersignal erzeugt. Die Signalverarbeitungseinrichtung bzw. eine mit der Spule des Empfängers verbundene Signalverarbeitungseinrichtung führt mithilfe des durch den Stromimpuls erzeugten Kalibriersignals eine Messwertkorrektur durch. Die jeweilige Signalverarbeitungseinrichtung kann aus der Antwort und der Messwertkorrektur ein Messergebnis ermitteln. Das Kalibriersignal enthält eine Information über einen Störeinfluss durch die Spule. "Messwertkorrektur" meint, dass dieser Störeinfluss durch die Signalverarbeitungseinrichtung ermittelt wird und als Messergebnis ein Ergebnis ausgegeben wird, dass diesen ermittelten Störeinfluss nicht mehr umfasst. Mit geringem technischem Aufwand wird so ein Messergebnis erhalten, bei dem verfälschende Störeinflüsse reduziert sind. Messergebnisse können daher besonders genau ermittelt werden.

Vorteilhaft ist die Kalibriereinrichtung so eingerichtet, dass eine Messung unterbrochen wird und während der Unterbrechung der Stromimpuls in die Spule eingeleitet wird. "Unterbrechen" meint, dass eine Messpause eingelegt wird. Nach Ablauf der Messpause wird also die Messung fortgesetzt. Es können so Störeinflüsse im Verlaufe einer Messung ermittelt werden. Hierdurch gelingt es weiter verbessert, Messergebnisse besonders genau zu ermitteln. Eine Messung kann unterbrochen werden, indem der Sender vorrübergehend abgeschaltet wird und folglich dann kein Messsignal gesendet wird.

In einer Ausführungsform umfasst die Kalibriereinrichtung eine Schalteinrichtung, die so eingerichtet ist, dass durch Einschalten und anschließendes Ausschalten der Schalteinrichtung der Stromimpuls in die Spule eingeleitet werden kann. Mit technisch einfachen Mitteln kann so der Stromimpuls erzeugt werden. Auch ist es mit technisch einfachen Mitteln so möglich, während einer Messpause einen Stromimpuls in die Spule einzuleiten.

Vorteilhaft ist die Signalverarbeitungseinrichtung so eingerichtet, dass diese ein Signal als Kalibriersignal verwendet, das durch die Spule nach dem Ausschalten der Schalteinrichtung und vor der Durchführung oder Fortsetzung einer Messung erzeugt wird. Das Kalibriersignal ist bei dieser Ausgestaltung also eine Antwort im Anschluss an den in die Spule eingeleiteten Stromimpuls. Dies trägt weiter verbessert dazu bei, ein Messsignal besonders genau ermitteln zu können.

Die Schalteinrichtung umfasst vorzugsweise eine Gleichspannungsquelle und einen ersten elektrischen Widerstand. Die Gleichspannungsquelle ist mit dem ersten elektrischen Widerstand verbunden. Damit ist gemeint, dass es einen elektrischen Leiter gibt, der einerseits mit der Gleichspannungsquelle elektrisch verbunden ist und andererseits mit dem ersten elektrischen Widerstand, so dass ein Strom von der Gleichspannungsquelle zu dem ersten elektrischen Widerstand fließen kann. Der elektrische Leiter kann ein aus Metall bestehender Draht sein oder einen solchen Draht umfassen. Der elektrische Leiter kann eine Leiterbahn einer Platine sein. Der elektrische Leiter kann aus Kupfer bestehen.

Der erste elektrische Widerstand ist mit einem zweiten elektrischen Widerstand durch einen elektrischen Leiter verbunden, so dass ein Strom von der Gleichspannungsquelle durch den ersten Widerstand hindurch zu dem zweiten elektrischen Widerstand fließen kann. Der zweite elektrische Widerstand ist durch einen elektrischen Leiter mit der Spule verbunden, so dass der Strom von dem ersten elektrischen Widerstand durch den zweiten elektrischen Widerstand hindurch in die Spule hinein fließen kann.

Die elektrische Verbindung bzw. der elektrische Leiter zwischen dem ersten und dem zweiten elektrischen Widerstand ist über einen Schalter mit Masse elektrisch verbunden und zwar durch elektrische Leiter. Bei geschlossenem Schalter fließt Strom von der Gleichstromquelle zur Masse. Bei geöffnetem Schalter kann Strom nicht von der Gleichstromquelle zur Masse fließen. Dieser fließt dann zur Spule. Wird der Schalter geöffnet und im Anschluss daran wieder geschlossen, so wird dadurch ein Stromimpuls in die Spule eingeleitet.

Die Schalteinrichtung umfasst einen Mikrokontroller, der so eingerichtet ist, dass durch den Mikrocontroller das Öffnen und Schließen des Schalters gesteuert werden kann.

Insgesamt ist diese Schalteinrichtung in der Lage, innerhalb einer kurzen Messpause einen Stromimpuls in geeigneter Weise in die Spule einzuleiten, um so ein Kalibriersignal erzeugen zu können.

Der erste elektrische Widerstand ist vorteilhaft wenigstens 1000000 mal größer als der Kurzschlusswiderstand des Schalters, um den Strom nahezu vollständig über den geschlossenen Schalter ableiten zu können, sodass er nicht über den zweiten Widerstand fließt. Der Kurzschlusswiderstand ist vorteilhaft kleiner als 10 mΩ. Der erste elektrische Widerstand kann 10 kΩ bis 30 kΩ betragen.

Der zweite elektrische Widerstand ist vorteilhaft größer als der erste Widerstand. Der zweite elektrische Widerstand kann 100 kΩ bis 300 kΩ betragen.

Die Signalverarbeitungseinrichtung ist vorteilhaft so eingerichtet, dass diese während des Betriebs eine vorgegebene Schwingungsgleichung an das Kalibriersignal anpasst. Es werden durch das Anpassen Parameter der Schwingungsgleichung ermittelt. Aus den Parametern wird mithilfe einer Frequenzgleichung ein Korrekturwert ermittelt. Durch die Signalverarbeitungseinrichtung kann auf diese Weise ein um einen Korrekturwert bereinigtes Messsignal ermittelt werden.

Vorteilhaft steuert eine Kalibriereinrichtung eine Messung so, dass eine Messung wiederkehrend unterbrochen wird und während einer jeden Unterbrechung die Kalibriereinrichtung einen Stromimpuls in die Spule einleitet. Zeitliche Änderungen von Störeinflüssen können so kontinuierlich berücksichtigt werden. Es ist dadurch möglich, weiter verbessert ein Messergebnis zu ermitteln.

Der Sender kann eine elektrische Spannungsquelle umfassen, mit der eine Spannung an einer Spule des Senders oder an einen elektrischen Schwingkreis des Senders angelegt werden kann, um ein magnetisches oder ein elektromagnetisches Messsignal zu erzeugen. Der Sender und/oder der Empfänger können ein oder mehrere Spulen umfassen. Die Signalverarbeitungseinrichtung kann einen Verstärker umfassen, mit dem die Antwort verstärkt wird.

Die Signalverarbeitungseinrichtung kann einen Analog-Digital-Wandler umfassen, mit dem die Antwort digitalisiert werden kann. Die Signalverarbeitungseinrichtung kann einen Prozessor umfassen, mit dem die Antwort ausgewertet wird. Die Signalverarbeitungseinrichtung kann eine Ausgabeeinrichtung umfassen, mit der eine verarbeitete Antwort, also ein Messwert, ausgegeben wird.

Die Messvorrichtung kann so eingerichtet sein, dass durch diese eine Phasendifferenz zwischen Messsignal und Antwort ermittelt wird und die ermittelte Phasendifferenz ausgewertet wird. Die Messvorrichtung kann so eingerichtet sein, dass diese für die Analyse eines Untergrunds eingesetzt werden kann. Die Messvorrichtung kann so eingerichtet sein, dass mit dieser ein Maß für die elektrische Leitfähigkeit eines Untergrunds ermittelt werden kann.

Die Ausgabeeinrichtung kann einen Monitor und/oder einen Lautsprecher umfassen, um die verarbeitete Antwort ausgegeben. Die Ausgabeeinrichtung kann eine Datenschnittstelle umfassen, über die die verarbeitete Antwort an ein anderes Gerät übermittelt werden kann.

Die Messvorrichtung kann zur Messung der scheinbaren elektrischen Leitfähigkeit von Böden eingerichtet sein. Die Messvorrichtung kann so eingerichtet sein, dass eine Untersuchung eines oberflächennahen Bodens bis beispielsweise 40 Meter oder 50 Meter Tiefe möglich ist.

Eine dafür geeignete Messvorrichtung umfasst typischer Weise einen Sender mit einer Spule, auch "Sendespule" genannt, und einen Empfänger mit ein oder mehreren Spulen, auch "Empfängerspule(n)" genannt. Es ist ein vorgegebener Abstand zwischen Sendespule und den ein oder mehreren Empfängerspulen vorhanden. Durch Anregen der Sendespule mit einem Wechselstrom im Frequenzbereich von typischerweise zwischen 100 Hz bis 100 kHz kann ein magnetisches Feld erzeugt werden, das auch als Primärfeld bezeichnet wird. Aufgrund der elektrischen Leitfähigkeit des Bodens werden durch das Primärfeld Induktionsströme hervorgerufen, welche wiederum ein magnetisches Feld, das sogenannte Sekundärfeld, hervorrufen. Das Sekundärfeld ist in der Regel einige Größenordnungen kleiner als das Primärfeld. Der Empfänger kann beide Felder zusammen messen, um daraus die scheinbare elektrische Leitfähigkeit (ECa) eines Bodens zu ermitteln.

Störeinflüsse können die Genauigkeit eines Messergebnisses beeinträchtigen. Solche Störeinflüsse können beispielsweise auf Temperatureinflüssen oder Rauschen beruhen. Durch die vorliegende Erfindung können solche Störeinflüsse reduziert werden. Messergebnisse können so verbessert werden.

Eine jede Spule kann zu Störeinflüssen führen. Durch die vorliegende Erfindung ist es möglich, einen jeden Störeinfluss einer jeden Spule zumindest zu reduzieren. Eine erfindungsgemäße Messvorrichtung ist entsprechend skalierbar.

Auch weitere Bauteile wie Analog - Digital - Wandler können zu temperaturabhängigen Störeinflüssen führen. Um auch solche Störeinflüsse zu reduzieren, gibt es bevorzugt für die entsprechenden Bauteile Temperatursensoren, mit denen die Temperaturen des jeweiligen Bauteils gemessen werden. Beispielsweise anhand von Kalibrierungsmessungen kann der Störeinfluss in Abhängigkeit von der Temperatur bekannt sein. Es kann so mithilfe von gemessenen Temperaturen der jeweilige Störeinfluss ermittelt werden. Auf dieser Basis können weitere Korrekturwerte für die jeweiligen Bauteile erstellt werden. Auch diese Korrekturwerte werden vorzugsweise genutzt, um einen Messwert zu erhalten, der möglichst nicht durch solche Störeinflüsse verfälscht wird.

Die Erfindung betrifft auch ein Verfahren für den Betrieb einer Messvorrichtung, bei dem innerhalb einer Sekunde eine Messung zumindest einmal, bevorzugt mehrmals, unterbrochen wird, innerhalb einer jeden Messpause ein Kalibriersignal erzeugt wird, um unter Einbeziehung der Kalibriersignale Messergebnisse zu ermitteln. Es werden so kontinuierlich Störeinflüsse ermittelt. Es werden Messergebnisse erhalten, die durch diese Störeinflüsse nicht beeinflusst sind. Es kann daher besonders genau gemessen werden, ohne dafür einen übermäßig großen Aufwand betreiben zu müssen.

Es zeigen:

Figur 1: Blockschaltbild einer Messvorrichtung;
Figur 2: Strompulse und daraus resultierende Kalibriersignale;
Figur 3: Kalibriereinrichtung

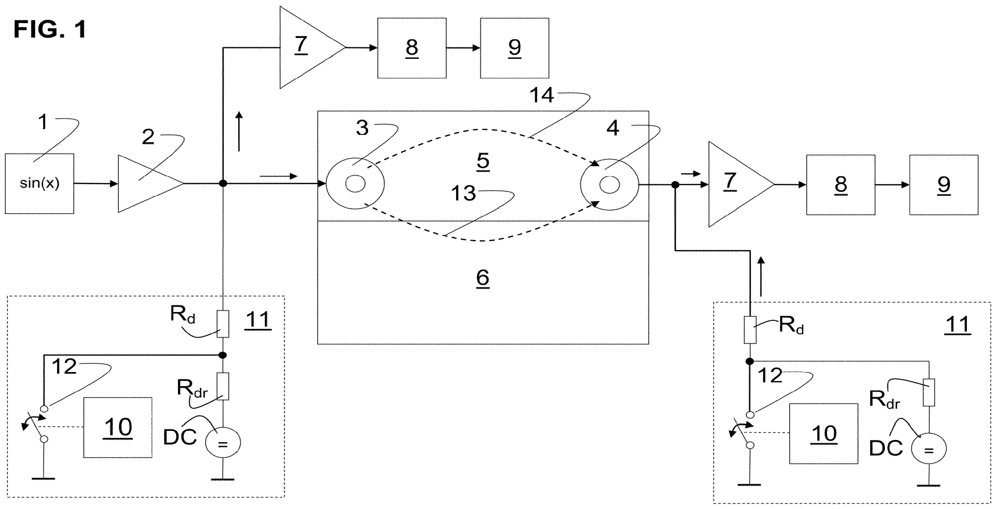

Wie in der Figur 1 gezeigt, kann die Messvorrichtung eine Wechselstromquelle mit einem Wechselstromgenerator 1 und einem elektronischen Verstärker 2 umfassen. Der Sender kann eine Sendespule 3 aufweisen. Der Empfänger kann eine Empfängerspule 4 aufweisen. Sendespule 3 und Empfängerspule 4 können räumlich voneinander getrennt sein. Sendespule 3 und Empfängerspule 4 können in Luft 5 oberhalb eines Bodens 6 angeordnet sein, um den Boden 6 untersuchen zu können.

Eine mit der Sendespule 3 verbundene Signalverarbeitungseinrichtung kann einen elektronischen Verstärker 7, einen Analog - Digital - Wandler 8 und eine Signalverarbeitung 9 umfassen. Die Signalverarbeitung 9 kann einen Mikrokontroller aufweisen. Eine Kalibriereinrichtung kann eine Steuerung 10, eine Bauteilgruppe oder Schaltkreis 11 und einen elektrischen Schalter 12 umfassen, um einen elektrischen Impuls in die Empfängerspule 4 einleiten zu können.

Für eine Messung kann durch die Wechselstromquelle 1, 2 ein Wechselstrom in die Sendespule 3 eingeleitet werden. Die Sendespule 3 erzeugt dadurch eine elektromagnetische Welle. Ein Anteil 13 der elektromagnetischen Welle passiert den Boden 6 und gelangt so zur Empfängerspule 4. Ein Anteil 14 der elektromagnetischen Welle gelangt ausschließlich durch die Luft 5 hindurch zur Empfängerspule 4. Der Boden 6 bewirkt eine Phasenverschiebung des Anteils 13 relativ zum Anteil 14. Durch diese Phasenverschiebung steht ein Maß für die Charakterisierung des Bodens 6 zu Verfügung. In der Empfängerspule 4 wird durch die elektromagnetische Welle 13, 14 eine Antwort induziert. Die Antwort wird an die Signalverarbeitungseinrichtung 7, 8, 9 weitergeleitet, die aus der Antwort einen Messwert ermittelt.

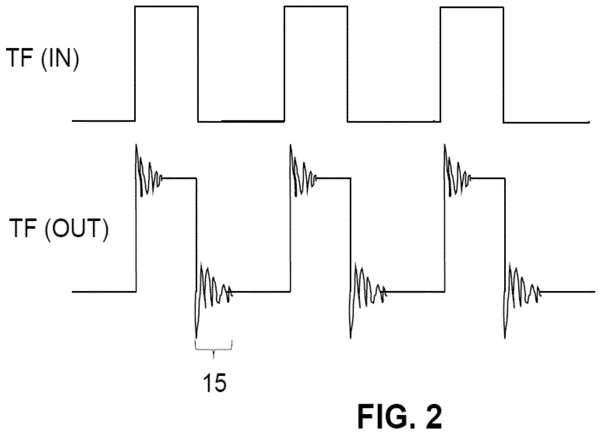

Beispielsweise gesteuert durch eine Steuerung kann die Wechselstromquelle 1, 2 vorrübergehend abgeschaltet werden. Innerhalb einer so entstandenen Messpause kann gesteuert durch die Steuerung 10 ein Stromimpuls in die Empfängerspule 4 eingeleitet werden. Die Steuerung 10 kann beispielsweise den Schalter 12 öffnen und schließen, um so einen Stromimpuls in die Empfängerspule 4 einzuleiten. Dies kann periodisch geschehen. So zeigt die Figur 2 rechteckförmige Stromimpulse TF(IN), die während Messpausen periodisch in die Empfängerspule 4 eingeleitet werden. Hierdurch erzeugt die Empfängerspule 4 eine in der Figur 2 gezeigte Antwort TF(OUT). Als Kalibriersignal kann nun der Anteil 15 der Antwort TF(OUT) verwendet werden. Das Kalibriersignal 15 schließt sich zeitlich an das Ende eines Stromimpulses an. Zeitlich nach dem Ende eines Kalibriersignals kann eine Messung fortgesetzt werden, also die Wechselstromquelle 1, 2 beispielsweise wieder eingeschaltet werden. Das Kalibriersignal 15 kann wie in der Figur 2 gezeigt eine gedämpfte Schwingung sein.

Die Signalverarbeitungseinrichtung 7, 8, 9 verarbeitet sowohl ein von der Empfängerspule 4 stammendes Messsignal als auch ein von der Empfängerspule 4 stammendes Kalibriersignal 15, um hieraus einen Messwert zu ermitteln.

Eine Kalibrierungseinrichtung kann auch für eine Sendespule 3 vorgesehen sein, wie dies in der Figur 1 gezeigt wird. Umfasst ein Sender oder ein Empfänger eine Mehrzahl von Spulen, so kann für jede weitere Spule eine weitere Kalibrierungseinrichtung vorgesehen sein. Die Messvorrichtung ist in diesem Sinne skalierbar.

Beispielsweise kann die nachfolgende von der Zeit t abhängende Schwingungsfunktion *TFA*(*t*) an das Kalibriersignal 15 durch die Signalverarbeitungseinrichtung 7, 8, 9 angepasst werden.

$$ TFA(t) = Ae^{-\alpha t}\mathrm{Re}\big(e^{j(\omega_d t + \phi)}\big) + B. $$

Die so ermittelten Parameter können in die nachfolgende Frequenzfunktion eingesetzt werden:

$$ G_{TFA}(j\omega) = \frac{j\omega + \alpha}{(j\omega + \alpha)^2 + \omega_d^2}. $$

Der so ermittelte Wert $G_{TFA}(j\omega)$ ist ein Maß für die durch die Spule verursachte Phasenverschiebung und kann daher ein Korrekturwert sein. Dieses Maß kann bei der Ermittlung des Messwertes durch die Signalverarbeitungseinrichtung 7, 8, 9 berücksichtigt werden.

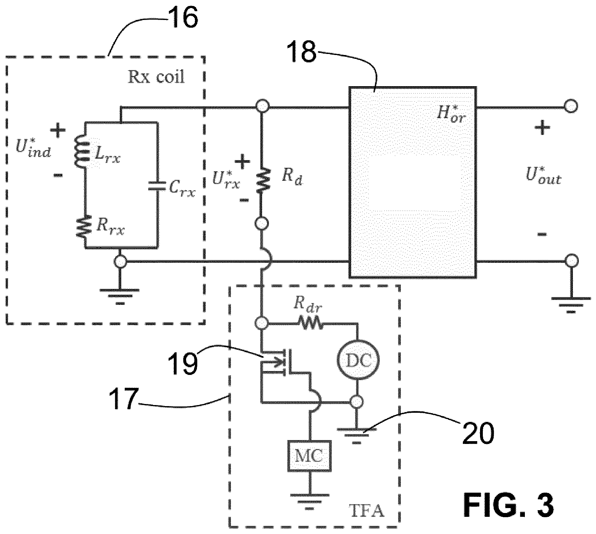

Die Figur 3 zeigt weitere mögliche Einzelheiten. Gezeigt werden ein Ersatzschaltbild 16 für eine Spule "Rx coil", eine Schalteinrichtung 17 und eine Signalverarbeitungseinrichtung 18. Die Schalteinrichtung 17 umfasst eine Gleichspannungsquelle DC. Die Gleichspannungsquelle DC ist durch einen elektrischen Leiter mit einem ersten elektrischen Widerstand $R_{dr}$ verbunden. Der erste elektrische Widerstand $R_{dr}$ ist durch einen elektrischen Leiter mit einem zweiten elektrischen Widerstand $R_d$ verbunden. Der erste elektrische Widerstand $R_{dr}$ kann 20 kΩ betragen. Der zweite elektrische Widerstand $R_d$ kann 200 kΩ betragen. Der elektrische Leiter zwischen dem ersten elektrischen Widerstand $R_{dr}$ und dem zweiten elektrischen Widerstand $R_d$ ist mit einem elektrischen Schalter 19 verbunden, der gesteuert durch einen Mikrokontroller MC geöffnet und geschlossen werden kann. Ist der elektrische Schalter 19 geschlossen, so fließt ein elektrischer Strom von der Gleichspannungsquelle DC zur Masse 20. Wird der elektrische Schalter 19 gesteuert durch den Mikrokontroller MC geöffnet und wieder geschlossen, so wird wie in der Figur 2 gezeigt ein elektrischer Impuls in die Spule Rx coil eingeleitet.

Bezugszeichenliste

1:      Wechselstromgenerator
2:      Verstärker / Elektronik
3:      Sendespule
4:      Empfängerspule
5:      Luft
6:      Boden
7:      Verstärker/ Elektronik
8:      ADC, Analog - Digital - Wandler
9:      Signalverarbeitung
10:     Steuerung
11:     TFA
12:     Schalter
13:     elektromagnetische Welle
14:     elektromagnetische Welle

15:     Kalibriersignal
16:     Ersatzschaltbild für eine Spule "Rx coil"
17:     Schalteinrichtung
18:     Signalverarbeitungseinrichtung
19:     Schalter
20:     Masse
Dc:     Gleichspannungsquelle
$R_{dr}$:     erster elektrischer Widerstand
$R_d$:     zweiter elektrischer Widerstand

**Patentansprüche**

1.  Messvorrichtung mit einem Sender (1, 2, 3) für ein Senden eines Messsignals, einem Empfänger (4) für ein Empfangen einer Antwort auf das gesendete Messsignal und einer Signalverarbeitungseinrichtung (7, 8, 9; 18) für eine Ermittlung eines Messergebnisses aus der Antwort, wobei der Sender und/oder der Empfänger eine Spule (3; 4; 16) aufweisen, **dadurch gekennzeichnet, dass** die Messvorrichtung eine Kalibriereinrichtung für eine Reduzierung eines Störeinflusses auf das Messergebnis aufweist, wobei die Kalibriereinrichtung so eingerichtet ist, dass

    von einer Stromquelle (DC) ein Stromimpuls in die Spule (3; 4; 16) des Empfängers eingeleitet werden kann und die Signalverarbeitungseinrichtung (7, 8, 9; 18) für die Ermittlung des Messergebnisses aus der Antwort mithilfe eines durch den Stromimpuls erzeugten Kalibriersignals eine Messwertkorrektur durchführen und ein Messergebnis aus der Antwort und der Messwertkorrektur ermitteln kann, und/oder von einer Stromquelle (DC) ein Stromimpuls in die Spule (3; 16) des Senders eingeleitet werden kann und eine mit der Spule (3; 16) des Empfängers verbundene Signalverarbeitungseinrichtung (7, 8, 9; 18) mithilfe eines durch den Stromimpuls erzeugten Kalibriersignals die Messwertkorrektur durchführen und das Messergebnis aus der Antwort und der Messwertkorrektur ermitteln kann.

2.  Messvorrichtung nach Anspruch 1, **dadurch gekennzeichnet, dass** die Kalibriereinrichtung so eingerichtet ist, dass während der Unterbrechung einer Messung der Stromimpuls in die Spule (3; 4; 16) eingeleitet wird.

3.  Messvorrichtung nach einem der vorhergehenden Ansprüche, **dadurch gekennzeichnet, dass** die Kalibriereinrichtung eine Schalteinrichtung (17) umfasst, die so eingerichtet ist, dass durch Einschalten und anschließendes Ausschalten der Schalteinrichtung (17) der Stromimpuls in die Spule (3; 4; 16) eingeleitet werden kann.

4.  Messvorrichtung nach dem vorhergehenden Anspruch, **dadurch gekennzeichnet, dass** die Signalverarbeitungseinrichtung (7, 8, 9; 18) so eingerichtet ist, dass diese ein Signal als Kalibriersignal verarbeitet, das durch die Spule (3; 4; 16) nach dem Ausschalten der Schalteinrichtung (17) und vor der Durchführung einer Messung erzeugt wird.

5.  Messvorrichtung nach einem der beiden vorhergehenden Ansprüche, **dadurch gekennzeichnet, dass** die Schalteinrichtung (17) eine Gleichspannungsquelle (DC) umfasst, die mit einem ersten elektrischen Widerstand ($R_{dr}$) verbunden ist und der erste elektrische Widerstand ($R_{dr}$) mit einem zweiten elektrischen Widerstand ($R_d$) verbunden ist und der zweite elektrische Widerstand ($R_d$) mit der Spule (3; 4; 16) verbunden ist und die elektrische Verbindung zwischen dem ersten und dem zweiten elektrischen Widerstand ($R_{dr}$, $R_d$) über einen Schalter (19) mit Masse (20) verbunden ist, so dass bei geschlossenem Schalter (20) Strom von der Gleichstromquelle (DC) zur Masse (20) fließt und bei geöffnetem Schalter (19) Strom von der Gleichspannungsquelle (DC) zur Spule (3; 4; 16) fließt, und die Schalteinrichtung (17) einen Mikrocontroller (MC) umfasst, der so eingerichtet ist, dass durch den Mikrocontroller (MC) das Öffnen und Schließen des Schalters (19) gesteuert werden kann.

6.  Messvorrichtung nach dem vorhergehenden Anspruch, **dadurch gekennzeichnet, dass** der erste elektrische Widerstand ($R_{dr}$) vorteilhaft 1000000 mal größer ist als ein Kurzschlusswiderstand des Schalters (19).

7.  Messvorrichtung nach dem vorhergehenden Anspruch, **dadurch gekennzeichnet, dass** der zweite elektrische Widerstand ($R_d$) größer als der erste Widerstand ($R_{dr}$) ist.

8.  Messvorrichtung nach einem der drei vorhergehenden Ansprüche, **dadurch gekennzeichnet, dass** der erste elektrische Widerstand ($R_{dr}$) 10 kΩ bis 30 kΩ beträgt und/oder der zweite elektrische Widerstand ($R_d$) 100 kΩ bis 300 kΩ beträgt.

9.  Messvorrichtung nach einem der vier vorhergehenden Ansprüche, **dadurch gekennzeichnet, dass** der Kurzschlusswiderstand des Schalters (19) kleiner als 10 mΩ ist.

10. Messvorrichtung nach einem der vorhergehenden Ansprüche, **dadurch gekennzeichnet, dass** die Signalverarbeitungseinrichtung (7, 8, 9; 18) so eingerichtet ist, dass diese während des Betriebs eine vorgegebene Schwingungsgleichung an das Kalibriersignal anpasst und dadurch Parameter der Schwingungsgleichung ermittelt und aus den Parametern mithilfe einer Frequenzgleichung einen Korrekturwert ermittelt und ein um den Korrekturwert bereinigtes Messsignal ermittelt.

11. Messvorrichtung nach einem der vorhergehenden Ansprüche, **dadurch gekennzeichnet, dass** die Kalibriereinrichtung eine Messung so steuert, dass eine Messung wiederkehrend unterbrochen wird und während einer jeden Unterbrechung die Kalibriereinrichtung einen Stromimpuls in die Spule (3; 4; 16) einleitet.

12. Messvorrichtung nach einem der vorhergehenden Ansprüche, **dadurch gekennzeichnet, dass** ein oder mehrere Temperatursensoren vorhanden sind, durch die die Temperatur von ein oder mehreren Bauteilen gemessen wird und anhand von gemessenen Temperaturen ein oder mehrere Korrekturwerte ermittelt werden und durch die Signalverarbeitungseinrichtung (7, 8, 9; 18) ein Messergebnis auch unter Berücksichtigung der ein oder mehreren weiteren Korrekturwerte ermittelt werden kann.

13. Verfahren für den Betrieb einer Messvorrichtung nach einem der vorhergehenden Ansprüche, **dadurch gekennzeichnet, dass** innerhalb einer Sekunde eine Messung zumindest einmal, bevorzugt mehrmals, unterbrochen wird, innerhalb einer jeden Messpause ein Kalibriersignal erzeugt wird, um unter Einbeziehung der Kalibriersignale Messergebnisse zu ermitteln.

## Claims

1. Measuring device having a transmitter (1, 2, 3) for transmitting a measurement signal, a receiver (4) for receiving a response to the transmitted measurement signal and a signal processing device (7, 8, 9; 18) for determining a measurement result from the response, the transmitter and/or the receiver having a coil (3; 4; 16), **characterized in that** the measuring device comprises a calibration device for reducing an interference influence on the measurement result, wherein the calibration device is configured such that

a current pulse can be introduced into the coil (3; 4; 16) of the receiver from a current source (DC) and the signal processing device (7, 8, 9; 18) can perform a measurement value correction using a calibration signal generated by the current pulse for determining the measurement result from the response and can determine a measurement result from the response and the measurement value correction, and/or
a current pulse can be introduced into the coil (3; 16) of the transmitter from a current source (DC) and a signal processing device (7, 8, 9; 18) connected to the coil (3; 16) of the receiver can perform the measurement value correction using a calibration signal generated by the current pulse and determine the measurement result from the response and the measurement value correction.

2. Measuring device according to claim 1, **characterized in that** the calibration device is configured such that during the interruption of a measurement the current pulse is introduced into the coil (3; 4; 16).

3. Measuring device according to one of the preceding claims, **characterized in that** the calibration device comprises a switching device (17) configured such that the current pulse can be introduced into the coil (3; 4; 16) by switching on and subsequently switching off the switching device (17).

4. Measuring device according to the preceding claim, **characterized in that** the signal processing device (7, 8, 9; 18) is configured such that it processes as a calibration signal a signal generated by the coil (3; 4; 16) after the switching device (17) is switched off and before a measurement is performed.

5. Measuring device according to one of the two preceding claims, **characterized in that** the switching device (17) comprises a DC voltage source (DC) connected to a first electrical resistor (Rdr) and the first electrical resistor (Rdr) is connected to a second electrical resistor (Rd) and the second electrical resistor (Rd) is connected to the coil (3; 4; 16) and the electrical connection between the first and second electrical resistors (Rdr, Rd) is connected to ground (20) via a switch (19), so that, current flows from the direct current source (DC) to ground (20) when the switch (20) is closed and current flows from the direct current source (DC) to the coil (3; 4; 16) when the switch (19) is open, and the switching device (17) comprises a microcontroller (MC) which is configured such that the opening and closing of the switch (19) can be controlled by the microcontroller (MC).

6. Measuring device according to the preceding claim, **characterized in that** the first electrical resistor (Rdr) is advantageously 1000000 times greater than a short-circuit resistance of the switch (19).

7. Measuring device according to the preceding claim, **characterized in that** the second electrical resistor (Rd) is greater than the first resistor (Rdr).

8. Measuring device according to one of the three preceding claims, **characterized in that** the first electrical resistor (Rdr) is 10 kΩ to 30 kΩ and/or the second electrical resistor (Rd) is 100 kΩ to 300 kΩ.

9. Measuring device according to one of the four preceding claims, **characterized in that** the short-circuit resistance of the switch (19) is less than 10 mΩ.

10. Measuring device according to one of the preceding claims, **characterized in that** the signal processing device (7, 8, 9; 18) is configured such that during operation it adapts a predetermined oscillation equation to the calibration signal and thereby determines parameters of the oscillation equation and determines a correction value from the parameters using a frequency equation and determines a measurement signal corrected by the correction value.

11. Measuring device according to one of the preceding claims, **characterized in that** the calibration device controls a measurement in such a way that a measurement is recurrently interrupted and during each interruption the calibration device introduces a current pulse into the coil (3; 4; 16).

12. Measuring device according to one of the preceding claims, **characterized in that** one or more temperature sensors are present, by means of which the temperature of one or more components is measured and one or more correction values are determined on the basis of measured temperatures and by means of the signal processing device (7, 8, 9; 18) a measurement result can also be determined taking into account the one or more further correction values.

13. Method for operating a measuring device according to one of the preceding claims, **characterized in that** within one second a measurement is interrupted at least once, preferably several times, within each measurement pause a calibration signal is generated in order to determine measurement results involving the calibration signals.

**Revendications**

1. Dispositif de mesure avec un émetteur (1, 2, 3) pour une émission d'un signal de mesure, un récepteur (4) pour une réception d'une réponse au signal de mesure émis et un dispositif de traitement de signal (7, 8, 9 ; 18) pour une détermination d'un résultat de mesure à partir de la réponse, dans lequel l'émetteur et/ou le récepteur présentent une bobine (3 ; 4 ; 16), **caractérisé en ce que** le dispositif de mesure présente un dispositif de calibrage pour une réduction d'une influence perturbatrice sur le résultat de mesure, dans lequel le dispositif de calibrage est configuré de telle sorte que

une impulsion de courant peut être introduite dans la bobine (3 ; 4 ; 16) du récepteur par une source de courant (DC) et le dispositif de traitement de signal (7, 8, 9 ; 18) peut, pour la détermination du résultat de mesure à partir de la réponse, effectuer une correction de valeur de mesure à l'aide d'un signal de calibrage généré par l'impulsion de courant et déterminer un résultat de mesure à partir de la réponse et de la correction de valeur de mesure, et/ou

une impulsion de courant peut être introduite dans la bobine (3 ; 16) de l'émetteur par une source de courant (DC) et un dispositif de traitement de signal (7, 8, 9 ; 18) relié à la bobine (3 ; 16) du récepteur peut effectuer la correction de valeur de mesure à l'aide d'un signal de calibrage généré par l'impulsion de courant et déterminer le résultat de mesure à partir de la réponse et de la correction de valeur de mesure.

2. Dispositif de mesure selon la revendication 1, **caractérisé en ce que** le dispositif de calibrage est configuré de telle sorte que, pendant l'interruption d'une mesure, l'impulsion de courant est introduite dans la bobine (3 ; 4 ; 16).

3. Dispositif de mesure selon l'une des revendications précédentes, **caractérisé en ce que** le dispositif de calibrage comprend un dispositif de commutation (17) qui est configuré de telle sorte que l'impulsion de courant peut être introduite dans la bobine (3 ; 4 ; 16) par mise en marche et à la suite mise hors tension du dispositif de commutation (17).

4. Dispositif de mesure selon la revendication précédente, **caractérisé en ce que** le dispositif de traitement de signal (7, 8, 9 ; 18) est configuré de telle sorte que celui-ci traite un signal, qui est généré par la bobine (3 ; 4 ; 16) après la mise hors tension du dispositif de commutation (17) et avant l'exécution d'une mesure, comme signal de calibrage.

5. Dispositif de mesure selon l'une des deux revendications précédentes, **caractérisé en ce que** le dispositif de commutation (17) comprend une source de tension continue (DC) qui est reliée à une première résistance électrique ($R_{dr}$) et la première résistance électrique ($R_{dr}$) est reliée à une deuxième résistance électrique ($R_d$) et la deuxième résistance électrique ($R_d$) est reliée à la bobine (3 ; 4 ; 16) et la connexion électrique entre la première et la deuxième résistance électrique ($R_{dr}$, $R_d$) est reliée à la masse (20) par l'intermédiaire d'un commutateur (19), de sorte que lorsque le commutateur (20) est fermé, le courant circule de la source de courant continu (DC) vers la masse (20) et lorsque le commutateur (19) est ouvert, le courant circule de la source de tension continue (DC) vers la bobine (3 ; 4 ; 16), et le dispositif de commutation (17) comprend un microcontrôleur (MC) qui est configuré de telle sorte que l'ouverture et la fermeture du commutateur (19) peuvent être commandées par le microcontrôleur (MC).

6. Dispositif de mesure selon la revendication précédente, **caractérisé en ce que** la première résistance électrique ($R_{dr}$) est avantageusement 1000000 fois supérieure à une résistance de court-circuit de l'interrupteur (19).

7. Dispositif de mesure selon la revendication précédente, **caractérisé en ce que** la deuxième résistance électrique ($R_d$) est supérieure à la première résistance ($R_{dr}$).

8. Dispositif de mesure selon l'une des trois revendications précédentes, **caractérisé en ce que** la première résistance électrique ($R_{dr}$) est de 10 K$\Omega$ à 30 k$\Omega$ et/ou la deuxième résistance électrique ($R_d$) est de 100 K$\Omega$ à 300 K$\Omega$.

9. Dispositif de mesure selon l'une des quatre revendications précédentes, **caractérisé en ce que** la résistance de court-circuit du commutateur (19) est inférieure à 10 m$\Omega$.

10. Dispositif de mesure selon l'une des revendications précédentes, **caractérisé en ce que** le dispositif de traitement de signal (7, 8, 9 ; 18) est configuré de telle sorte que celui-ci adapte, pendant le fonctionnement, une équation d'oscillation prédéterminée au signal de calibrage et détermine ainsi des paramètres de l'équation d'oscillation et détermine une valeur de correction à partir des paramètres à l'aide d'une équation de fréquence et détermine un signal de mesure épuré de la valeur de correction.

11. Dispositif de mesure selon l'une des revendications précédentes, **caractérisé en ce que** le dispositif de calibrage commande une mesure de telle sorte qu'une mesure est interrompue de manière répétée et que, pendant chaque interruption, le dispositif de calibrage introduit une impulsion de courant dans la bobine (3 ; 4 ; 16).

12. Dispositif de mesure selon l'une des revendications précédentes, **caractérisé en ce qu'**un ou plusieurs capteurs de température sont présents, au moyen desquels la température d'un ou de plusieurs composants de construction est mesurée et une ou plusieurs valeurs de correction sont déterminées à l'aide des températures mesurées et un résultat de mesure peut être déterminé par le dispositif de traitement de signal (7, 8, 9 ; 18) en tenant également compte de la ou des autres valeurs de correction.

13. Procédé pour le fonctionnement d'un dispositif de mesure selon l'une des revendications précédentes, **caractérisé en ce que**, en l'espace d'une seconde, une mesure est interrompue au moins une fois, de préférence plusieurs fois, un signal de calibrage est généré à l'intérieur de chaque pause de mesure, afin de déterminer des résultats de mesure en tenant compte des signaux de calibrage.

**FIG. 1**

TF (IN)

TF (OUT)

15

**FIG. 2**

FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19731560 A1
- EP 1289147 A1
- DE 102009026403 A1
- WO 2018014891 A1
- EP 2657726 A2
- DE 102012203111 A1
- US 20100241389 A1
- US 20110115497 A1
- US 20050190100 A1
- DE 102011083959 A1
- US 20120139776 A1